(19) Europäisches Patentamt
European Patent Office
Office européen des brevets

(11) **EP 4 409 301 B1**

(12) **FASCICULE DE BREVET EUROPEEN**

(45) Date de publication et mention
de la délivrance du brevet:
**22.07.2026 Bulletin 2026/30**

(21) Numéro de dépôt: **22790322.6**

(22) Date de dépôt: **28.09.2022**

(51) Classification Internationale des Brevets (IPC):
**G01R 1/067** *(2006.01)* **G01R 19/165** *(2006.01)*
**G01R 19/00** *(2006.01)*

(52) Classification Coopérative des Brevets (CPC):
**G01R 1/06766; G01R 19/0023;** G01R 1/06788;
G01R 19/16561

(86) Numéro de dépôt international:
**PCT/EP2022/077075**

(87) Numéro de publication internationale:
**WO 2023/052482 (06.04.2023 Gazette 2023/14)**

(54) **SONDE ACTIVE POUR LA MESURE DE TENSION EN IMPEDANCES ELEVEES**

AKTIVE SONDE ZUR SPANNUNGSMESSUNG BEI HOHEN IMPEDANZEN

ACTIVE PROBE FOR MEASURING VOLTAGE AT HIGH IMPEDANCES

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **30.09.2021 FR 2110332**

(43) Date de publication de la demande:
**07.08.2024 Bulletin 2024/32**

(73) Titulaire: **ATEQ**
**78340 Les Clayes-sous-Bois (FR)**

(72) Inventeur: **MAY, Thierry**
**78340 Les Clayes-sous-Bois (FR)**

(74) Mandataire: **Vidon Brevets & Stratégie**
**16B, rue de Jouanet**
**BP 90333**
**35703 Rennes Cedex 7 (FR)**

(56) Documents cités:
US-A- 4 042 881    US-A- 4 298 837
US-A- 4 527 118    US-A- 5 952 820

• **NORAS M A: "Ultra high impedance voltmeter for
electrostatic applications", CONFERENCE
RECORD OF THE 2005 IEEE INDUSTRY
APPLICATIONS CONFERENCE FORTIETH IAS
ANNUAL MEETING 2-6 OCT. 2005 KOWLOON,
HONG KONG, CHINA, IEEE, CONFERENCE
RECORD OF THE 2005 IEEE INDUSTRY
APPLICATIONS CONFERENCE FORTIETH IAS
ANNUAL MEETING (IEEE CAT., vol. 3, 2 October
2005 (2005-10-02), pages 2194 - 2197,
XP010842699, ISBN: 978-0-7803-9208-3, DOI:
10.1109/IAS.2005.1518751**

## Description

La présente invention se rapporte au domaine de la mesure de grandeurs électriques sur des circuits électroniques, circuits présentant plus particulièrement des impédances élevées et soumis à des tensions importantes, et notamment à une sonde configurée pour réaliser de telles mesures.

Dans le domaine de la mesure d'impédances et/ou de tensions, il est classique d'utiliser un multimètre pour réaliser ce genre de mesure. Le document US5952820 décrit un tel dispositif de mesure de la tension d'un circuit. Malheureusement, les multimètres du commerce font état d'une impédance d'entrée insuffisante, c'est-à-dire de l'ordre d'une dizaine de mégohms, en regard des impédances des circuits sur lesquels on souhaite réaliser des mesures. En effet, lesdits multimètres ne permettent pas de réaliser des mesures de tension correctes, surtout lorsque l'impédance du circuit sur lequel la mesure est réalisée est de l'ordre de la dizaine de mégohms ou au-delà. Le multimètre va notamment modifier les impédances qu'on cherche à mesurer, ce qui va entraîner une mesure erronée.

On peut notamment penser aux mesures d'impédance à réaliser lors de la conception du circuit d'alimentation haute-tension et/ou de régulation d'alimentation par exemple d'un spectromètre de masse, d'un diélectrimètre, d'un mégohmmètre... (et généralement tout circuit ayant trait à une application haute-tension). Ces circuits présentent généralement des ponts diviseurs résistifs dont l'impédance est supérieure à la dizaine de mégohms et des tensions à leurs bornes de l'ordre de la centaine de volts ou au-delà. Ce type d'application nécessite d'avoir un moyen de mesure performant, dont les mesures ne présenteront pas d'erreurs significatives.

Par ailleurs, pour effectuer de telles mesures, il est généralement nécessaire d'avoir des sondes raccordées à un multimètre au moyen de câbles de mesure. Ces câbles génèrent du bruit et des risques de boucles de couplage capacitif qui vont impacter l'exactitude de la mesure.

La présente invention permet ainsi de remédier à une ou plusieurs des problématiques évoquées ci-dessus et d'avoir une exactitude de mesure égale ou inférieure à 1 %.

L'invention est ainsi une sonde active de mesure d'une tension selon la revendication 1.

Une sonde selon l'invention embarquant un circuit d'adaptation d'impédance permet ainsi d'effectuer des mesures de haute impédance et d'obtenir la valeur mesurée sur une sortie en basse impédance, cela permet notamment de s'affranchir des phénomènes perturbateurs (tels que les couplages capacitifs et inductifs, ainsi que des champs électromagnétiques parasites).

Le signal basse impédance peut par exemple être de l'ordre de la dizaine d'ohms.

Selon une autre caractéristique possible, la sortie basse impédance dudit circuit d'adaptation d'impédance présente une impédance égale ou inférieure à 50 Ohms

Selon une autre caractéristique possible, ladite sonde selon l'invention comprend un boitier, le circuit d'adaptation d'impédance et ladite pointe de touche étant disposés, au moins partiellement, dans ledit boitier.

Selon une autre caractéristique possible, ladite sonde comprend un voltmètre relié à une sortie du circuit d'adaptation d'impédance.

Selon une autre caractéristique possible, ledit circuit d'adaptation d'impédance est configuré pour être relié à un oscilloscope, notamment au moyen d'une sortie destinée à être raccordée à un oscilloscope.

Le fait de pouvoir relier la sortie dudit circuit d'adaptation d'impédance à un oscilloscope permet de visualiser facilement la tension mesurée par la sonde selon l'invention.

Selon une autre caractéristique possible, ladite sonde comprend une batterie, par exemple disposée dans le boitier. Cette configuration permet notamment d'avoir une sonde autonome, facilement manipulable et transportable.

Selon une autre caractéristique possible, l'impédance d'entrée et l'impédance de sortie du circuit d'adaptation d'impédance présentent un rapport supérieur ou égal à 1000, et de préférence supérieur ou égal à 5000 (l'impédance d'entrée est donc très largement supérieure à l'impédance de sortie).

Selon une autre caractéristique possible, ladite pointe de touche est reliée directement audit circuit d'adaptation d'impédance.

Cette disposition des éléments de la sonde permet notamment d'avoir pas ou peu de câbles entre la pointe de mesure et le circuit permettant la mesure. Cela évite également la nécessité de blinder les câbles et permet d'avoir une sonde plus de compacte.

Le montage amplificateur non-inverseur comprend un amplificateur opérationnel AO1, ainsi qu'une résistance R5 disposée au niveau de l'entrée inverseuse dudit amplificateur opérationnel AO1.

Le montage amplificateur comprend également un anneau de garde entourant les entrées inverseuse et non inverseuse de l'amplificateur opérationnel AO1 et au moins partiellement la cinquième résistance R5.

Selon une autre caractéristique possible, le circuit d'adaptation d'impédance comprend au moins un composant et/ou un circuit de filtrage.

Selon une autre caractéristique possible, ledit au moins composant et/ou circuit de filtrage comprend une résistance et/ou une capacité.

Selon une autre caractéristique possible, ladite sonde est configurée pour mesurer une tension continue et/ou présentant une fréquence inférieure à 60 Hz.

La sonde selon l'invention est configurée pour mesurer une impédance supérieure à 10 Gigaohms (GΩ), préférentiellement comprise entre 10 et 50 Gigaohms (GΩ).

Selon une autre caractéristique possible, le circuit d'adaptation d'impédance présente une fonction de transfert H(p) comportant trois pôles et un zéro.

Selon une autre caractéristique possible, le circuit d'entrée présente une impédance d'entrée supérieure à 50 Gigaohms (GΩ).

Selon une autre caractéristique possible, le circuit d'entrée comprend un pont diviseur.

Ce pont diviseur peut, dans ce cas, être un pont diviseur résistif.

Selon une autre caractéristique possible, ledit circuit d'entrée comprend au moins une résistance R1 comportant au moins un anneau de garde fixé sur le corps de ladite résistance R1.

Selon une autre caractéristique possible, l'anneau de garde de ladite au moins une résistance R1 comprend une bague en inox fixée sur le milieu du corps de la résistance et une tresse métallique reliant ladite bague à une masse G.

Selon une autre caractéristique possible, le circuit d'entrée comprend au moins un condensateur C1.

Ledit condensateur C1 présente avantageusement une capacité comprise entre 1,5 et 55 picofarads.

Selon une autre caractéristique possible, le condensateur C1 dudit circuit d'entrée est disposé en parallèle de la résistance R1 dudit pont diviseur.

Selon une autre caractéristique possible, le condensateur C1 dudit circuit d'entrée est un condensateur variable ou ajustable, c'est-à-dire que sa capacité peut varier sur une plage déterminée, par exemple entre 1,5 et 55 picofarads. Le condensateur C1 est un condensateur d'accord et permet le réglage de l'amortissement du circuit, notamment lorsque celui-ci est soumis à un régime indiciel (le but étant d'éviter le suramortissement ou le sous-amortissement et d'avoir une mesure erronée).

Selon une autre caractéristique possible, le circuit d'adaptation d'impédance comprend un circuit de protection contre les surtensions.

Selon une autre caractéristique possible, ledit circuit de protection comprend deux transistors montés en diode, par exemple des transistors de type JFET (pour « Junction Field Effect Transistor » en langue anglaise). On notera que le fait qu'un transistor, notamment à effet de champ, soit monté en diode signifie que le drain et la source sont reliés entre eux (anode) et sont considérés comme un seul pôle, et que la grille (cathode) est considérée comme l'autre pôle.

L'invention sera mieux comprise, et d'autres buts, détails, caractéristiques et avantages de celles-ci apparaîtront plus clairement au cours de la description suivante d'un mode de réalisation particulier de l'invention, donnée uniquement à titre illustratif et non limitatif, en référence aux dessins annexés, sur lesquels :

- La [Fig.1], référencée [Fig.1], est une représentation très schématique d'une sonde de mesure selon l'invention ;
- la [Fig.2], référencée [Fig.2], est une représentation schématique du circuit d'adaptation d'impédance de la sonde de la [Fig.1] ;
- la [Fig.3], référencée [Fig.3], est une représentation schématique et agrandie d'une résistance du circuit de la [Fig.2], et
- la [Fig.4], référencée [Fig.4], est une représentation schématique électrique équivalente de la résistance de la [Fig.3].

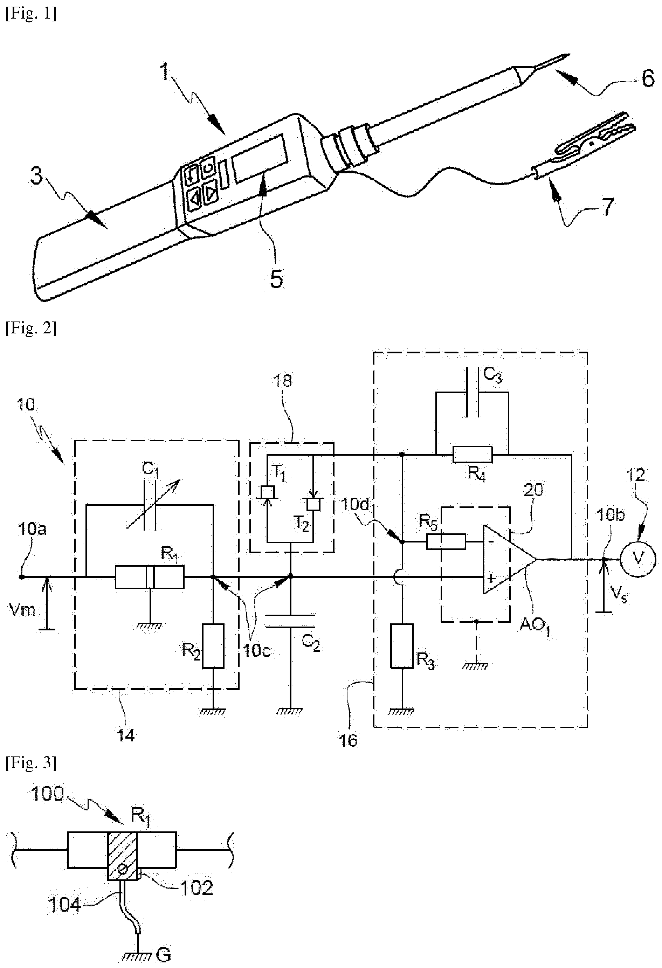

La [Fig.1] est une représentation très schématique d'une sonde 1 active de mesure d'une tension aux bornes d'une impédance de grande valeur.

On notera qu'on entend par « grandes impédances », des impédances supérieures à 10 gigaohms (GΩ), et préférentiellement des impédances comprises entre 10 et 50 gigaohms (GΩ).

Ladite sonde 1 active comprend ainsi un boitier 3, une interface homme-machine 5, par exemple intégrée dans le boitier 3, une pointe de touche 6 configurée pour une prise de mesure de tension, ainsi qu'une référence 7 de masse reliée à la pointe de touche 6 et destinée à être connectée à une masse de référence G.

Ladite sonde 1 comprend avantageusement une batterie (non représentée) pour alimenter les différents circuits et composants de ladite sonde 1, lui permettant ainsi d'être autonome et de ne pas nécessiter d'être reliée au secteur lors de son utilisation.

On notera qu'on entend par interface homme-machine, l'ensemble des éléments permettant à l'utilisateur d'interagir avec la sonde selon l'invention, plus particulièrement de contrôler la sonde selon l'invention et d'échanger des informations avec celle-ci.

La pointe de touche 6 se termine par une partie électriquement conductrice destinée à être appliquée au point d'un circuit présentant une grande impédance dont on cherche à mesurer une tension, tandis que la référence 7 se présente par exemple sous la forme d'une pince crocodile.

On notera qu'on entend par « sonde active », le fait que la sonde comprend un ou plusieurs composants actifs configurés pour traiter le signal de mesure et qui sont situés au plus proche de la pointe de touche 6, ceci notamment pour être le moins sensible aux diverses perturbations et diminuer ainsi les erreurs de mesure.

Comme illustré à la [Fig.2], ladite sonde 1 comprend ainsi un circuit d'adaptation d'impédance 10 et un voltmètre 12. Ledit circuit d'impédance 10 présente une entrée 10a correspondant à la pointe 6 de la sonde active 1, tandis que la masse G dudit circuit 10 est la masse à laquelle est reliée la référence 7 de ladite sonde 1.

Ledit circuit d'adaptation d'impédance 10 comprend au moins un circuit d'entrée 14, auquel est reliée l'entrée 10a, et un montage amplificateur 16 non-inverseur adapté aux grandes valeurs d'impédance, dont la sortie 10b est reliée au voltmètre 12 ou à une entrée oscilloscope. Le circuit d'entrée 14 et le montage amplificateur 16 sont montés en cascade.

Le circuit 10 présente avantageusement une impédance d'entrée et une impédance de sortie dont le rapport supérieur ou égal à 1000, et de préférence supérieur ou égal à 5000. L'impédance d'entrée dudit circuit 10 est donc très grande devant l'impédance de sortie du circuit 10.

Ledit au moins un circuit d'entrée 14 comprend plus particulièrement un montage du type pont diviseur résistif de tension (ou « pont diviseur »). Ledit pont diviseur comprend ainsi au moins deux résistances R1 et R2 (disposées de la manière adéquate), également désignées respectivement sous les termes de première résistance R1 et de deuxième résistance R2.

On notera par ailleurs que le circuit d'entrée 14 présente une impédance d'entrée supérieure à 50 Gigaohms (GΩ).

La deuxième résistance R2 est une résistance de pied dont l'une des extrémités est reliée à la masse G, tandis que la première résistance R1 est reliée, d'une part, à l'entrée 10a, et d'autre part, à la deuxième résistance R2. Une des extrémités des résistances R1 et R2 étant reliées au niveau de la sortie 10c du pont diviseur (la sortie 10c du pont diviseur correspondant également à l'entrée du montage 16).

Ledit circuit d'entrée 14 comprend également un condensateur C1 (également désigné sous le terme premier condensateur), de préférence variable ou ajustable, la valeur de la capacité du condensateur C1 pouvant varier sur une plage d'intervalles déterminée. Le condensateur C1 présente avantageusement une valeur de capacité comprise entre 1,5 et 55 picofarads.

Ledit condensateur C1 est par ailleurs disposé en parallèle de la résistance R1 du pont diviseur. Ledit condensateur C1 est donc relié d'une part, à l'entrée 10a, et d'autre part, à la sortie du pont diviseur 10c.

On notera que le circuit d'adaptation d'impédance 10 peut également comprendre un condensateur C2, également désigné sous le terme de deuxième condensateur, disposé en parallèle de la deuxième résistance R2 du pont diviseur.

Ce deuxième condensateur C2 permet notamment de filtrer des harmoniques et/ou de réduire le bruit présent à l'entrée 10a de la sonde 1, ledit condensateur C2 assure donc le rôle d'un composant de filtrage.

Ledit montage amplificateur 16, quant à lui, comprend ainsi un amplificateur opérationnel AO1, au moins trois résistances R3, R4 et R5, ainsi qu'un condensateur C3. Ces éléments sont également désignés respectivement sous le terme, troisième résistance R3, quatrième résistance R4, cinquième résistance R5 et troisième condensateur C3.

La sortie 10c du circuit d'entrée 14 est reliée à l'une des entrées du montage amplificateur 16, et plus particulièrement à l'entrée non-inverseuse de l'amplificateur opérationnel AO1.

La troisième résistance R3 est reliée par l'une de ses extrémités à la masse G, tandis que l'autre extrémité est reliée à l'entrée inverseuse de l'amplificateur opérationnel AO1. La troisième résistance R3, peut également être qualifiée de résistance de pied et participe au gain procuré par le montage 16 avec la quatrième résistance R4.

La cinquième résistance R5 est disposée au niveau de l'entrée inverseuse de l'amplificateur opérationnel AO1. L'une des extrémités de la résistance R5 est donc reliée à l'entrée inverseuse, tandis que l'autre extrémité est reliée à un nœud 10d, nœud 10d auquel est également relié la troisième résistance R3 (ainsi qu'à la quatrième résistance R4).

La quatrième résistance R4 et le troisième condensateur C3, disposés en parallèle l'un de l'autre, sont reliés, d'une part, au nœud 10d, et d'autre part, à la sortie de l'amplificateur opérationnel AO1 (la sortie de l'amplificateur AO1 correspondant à la sortie 10b du circuit d'adaptation d'impédance 10).

On notera que l'association de la quatrième résistance R4 et du troisième condensateur C3 en parallèle de ladite quatrième résistance R4 (et de sa position dans le circuit d'adaptation d'impédance 10) est un circuit de filtrage permettant notamment de filtrer les bruits liés à l'amplification du signal (mesuré).

Avantageusement, l'amplificateur opérationnel AO1 est un amplificateur opérationnel du type CMOS, (pour «Complementary Metal Oxide Semi-conductor » en langue anglaise), ce type d'amplificateur présentant de très faibles courants d'entrée, de l'ordre d'une dizaine de femtoampères.

Le montage amplificateur 16 comprend également un anneau de garde 20 entourant les entrées inverseuse et non inverseuse de l'amplificateur opérationnel AO1 et (au moins) partiellement la cinquième résistance R5. Ledit anneau de garde 20 évite notamment la migration des courants de fuite vers d'autres composants du circuit 10 présentant une différence de potentiel. L'anneau de garde 20 est également relié à la masse G du circuit d'adaptation d'impédance 10.

L'anneau de garde 20 est par exemple un ruban métallique, tel que du cuivre, disposé sur le circuit imprimé (PCB) sur lequel sont disposés les composants électroniques. Cet anneau de garde 20 permet notamment de préserver les éléments qu'il entoure de courants de fuites parasites.

En outre, le circuit d'adaptation d'impédance 10 comprend avantageusement un circuit de protection 18 contre les surtensions.

Ledit circuit de protection 18 comprend deux transistors T1 et T2 montés en diode, par exemple des transistors de type JFET. Il est particulièrement avantageux d'utiliser des transistors de ce type, car ceux-ci présentent de très faibles courants de fuites qui ne perturberont pas les mesures.

Le circuit d'adaptation d'impédance présente une fonction de transfert H(p) comportant trois pôles et un zéro, plus particulièrement la fonction de transfert présente la forme suivante :

$$H(p) = H_0 \left( \frac{1 + \frac{p}{\omega_1}}{1 + \frac{p}{\omega_2}} \right) \left( \frac{1 + \frac{p}{\omega_Z}}{1 + \frac{p}{\omega_3}} \right)$$

Avec $H_0 = \left( \frac{R_2}{R_1 + R_2} \right) \left( 1 + \frac{R_3}{R_4} \right)$ ; $\omega_1 = \frac{1}{R_1 C_1}$ ; $\omega_2 = \frac{1}{(R_1 // R_2)(C_2 + C_p)}$ ;

$\omega_3 = \frac{1}{R_4 C_3}$ ; $\omega_z = \frac{1}{(R_3 // R_4) C_3}$ ; où $C_p$ est la capacité d'entrée de l'amplificateur opérationnel AO1 ;

$\omega_1$, $\omega_2$, $\omega_3$ et $\omega_z$ sont les pulsations (généralement désignées sous les termes de « pulsations de coupure ») relatives aux pôles et au zéro de la fonction de transfert H(p) du circuit 10.

Avantageusement, les pulsations $\omega_1$ et $\omega_2$ sont égales, la pulsation $\omega_3$ est largement supérieure respectivement à $\omega_1$ et $\omega_2$, tandis que la pulsation $\omega_z$ est supérieure à $\omega_3$ (avantageusement au moins un rapport 10, et préférentiellement au moins un rapport 50).

On notera qu'on entend par « largement supérieur », au moins un rapport 100 entre la pulsation $\omega_3$ et les pulsations $\omega_1$ et $\omega_2$.

Ladite sonde 1 est ainsi configurée pour mesurer une tension continue et/ou présentant une fréquence inférieure à 60 Hz.

Comme cela est plus particulièrement illustré aux figures 2 et 3, la première résistance R1 comprend avantageusement un anneau de garde 100 fixé sur le corps de ladite résistance R1.

Ainsi, l'anneau de garde de ladite au moins une résistance R1 comprend une bague 102 en inox fixée sur le milieu du corps de la résistance R1 et une tresse métallique 104 reliant ladite bague à une masse G.

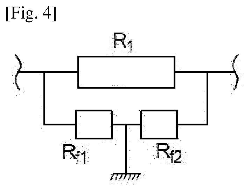

Comme cela est représenté sur le schéma électrique équivalent de la [Fig.4], l'anneau de garde permet de décomposer la résistance de fuite $R_f$ de la résistance R1 en deux résistances de fuites $R_{f1}$ et $R_{f2}$ disposées en parallèle l'une de l'autre, diminuant ainsi grandement la résistance de fuite associée à la résistance R1.

**Revendications**

1. Sonde (1) active de mesure d'une tension aux bornes d'une impédance de grande valeur d'au moins 10 Gigaohms (GΩ), ladite sonde (1) comprenant :

   - un circuit d'adaptation d'impédance (10) configuré, d'une part, pour présenter une impédance d'entrée au moins 100 fois supérieure à l'impédance à mesurer et, d'autre part, délivrer en sortie un signal basse impédance ;
   - une pointe de touche (6) configurée pour une prise de mesure et reliée audit circuit d'adaptation d'impédance (10) ;
   - une référence de masse (G) reliée audit circuit d'adaptation d'impédance (10) ;

   ledit circuit d'adaptation d'impédance (10) comprenant, montés en cascade, au moins un circuit d'entrée (14) et un montage amplificateur (16) non inverseur adapté aux grandes valeurs d'impédance.
   **caractérisée en ce que** le montage amplificateur (16) non-inverseur comprend un amplificateur opérationnel (AO1), ainsi qu'une résistance (R5) disposée au niveau de l'entrée inverseuse dudit amplificateur opérationnel (AO1),
   et **en ce que** le montage amplificateur (16) comprend un anneau de garde (20) entourant les entrées inverseuse et non inverseuse de l'amplificateur opérationnel (AO1) et au moins partiellement la cinquième résistance (R5).

2. Sonde (1) selon la revendication précédente, **caractérisée en ce que** la sortie basse impédance dudit circuit d'adaptation d'impédance (10) présente une impédance égale ou inférieure à 50 Ohms.

3. Sonde (1) l'une quelconque des revendications précédentes, caractérisée en que le circuit d'adaptation d'impédance (10) comprend au moins un composant (C2, C3, R4) et/ou un circuit de filtrage (18).

4. Sonde (1) selon l'une quelconque des revendications précédentes, **caractérisée en ce que** ladite sonde (1) est configurée pour mesurer une tension continue et/ou présentant une fréquence inférieure à 60 Hz.

5. Sonde (1) selon l'une quelconque des revendications précédentes, **caractérisée en ce qu'**elle est configurée pour mesurer une impédance supérieure à 10 Gigaohms (GΩ), préférentiellement comprise entre 10 et 50 Gigaohms (GΩ).

6. Sonde (1) selon l'une quelconque des revendications précédentes, **caractérisée en ce que** le circuit d'adaptation d'impédance (10) présente une fonction de transfert H(p) comportant trois pôles ($\omega_{1\text{-}3}$) et un zéro ($\omega_z$).

7. Sonde (1) selon la revendication précédente, **caractérisée en ce que** le circuit d'entrée (14) présente une impédance d'entrée supérieure à 50 Gigaohms (GΩ).

8. Sonde (1) selon l'une quelconque des revendications précédentes, **caractérisée en ce que** le circuit d'entrée (14) comprend un pont diviseur (R1 et R2).

9. Sonde (1) selon l'une quelconque des revendications précédentes, **caractérisée en ce que** ledit circuit d'entrée (14) comprend au moins une résistance (R1) comportant au moins un anneau de garde (100) fixé sur le corps de ladite résistance (R1).

10. Sonde (1) selon la revendication précédente **caractérisée en ce que** l'anneau de garde (100) de ladite au moins une résistance (R1) comprend une bague (102) en inox fixée sur le milieu du corps de la résistance (R1) et une tresse métallique (104) reliant ladite bague (102) à une masse (G).

**Patentansprüche**

1. Aktive Sonde (1) zur Messung einer Spannung an den Klemmen einer Hochimpedanz von mindestens 10 Gigaohm (GΩ), wobei die Sonde (1) umfasst:

   - eine Impedanzanpassungsschaltung (10), die so konfiguriert ist, dass sie einerseits eine Eingangsimpedanz aufweist, die mindestens 100-mal höher ist als die zu messende Impedanz, und andererseits am Ausgang ein niederohmiges Signal liefert;
   - eine Messspitze (6), die für einen Messanschluss konfiguriert und mit der Impedanzanpassungsschaltung (10) verbunden ist;
   - eine Massereferenz (G), die mit der Impedanzanpassungsschaltung (10) verbunden ist;

   wobei die Impedanzanpassungsschaltung (10) mindestens eine Eingangsschaltung (14) und eine nicht invertierende Verstärkerbaugruppe (16), die für hohe Impedanzwerte geeignet ist, umfasst, die in Kaskadenschaltung montiert sind,
   **dadurch gekennzeichnet, dass** die nicht invertierende Verstärkerbaugruppe (16) einen Betriebsverstärker (AO1) sowie einen Widerstand (R5) umfasst, der am invertierenden Eingang des Betriebsverstärkers (AO1) angeordnet ist,
   und dass die Verstärkerbaugruppe (16) einen Schutzring (20) umfasst, der den invertierenden und den nicht invertierenden Eingang des Betriebsverstärkers (AO1) und mindestens teilweise den fünften Widerstand (R5) umgibt.

2. Sonde (1) nach dem vorhergehenden Anspruch, **dadurch gekennzeichnet, dass** der niederohmige Ausgang der Impedanzanpassungsschaltung (10) eine Impedanz von 50 Ohm oder weniger aufweist.

3. Sonde (1) nach einem der vorhergehenden Ansprüche, **dadurch gekennzeichnet, dass** die Impedanzanpassungsschaltung (10) mindestens eine Komponente (C2, C3, R4) und/oder eine Filterschaltung (18) umfasst.

4. Sonde (1) nach einem der vorhergehenden Ansprüche, **dadurch gekennzeichnet, dass** die Sonde (1) so konfiguriert ist, dass sie eine Gleichspannung und/oder eine Spannung mit einer Frequenz von weniger als 60 Hz misst.

5. Sonde (1) nach einem der vorhergehenden Ansprüche, **dadurch gekennzeichnet, dass** sie so konfiguriert ist, dass sie eine Impedanz von mehr als 10 Gigaohm (G$\Omega$), vorzugsweise zwischen 10 und 50 Gigaohm (G$\Omega$), misst.

6. Sonde (1) nach einem der vorhergehenden Ansprüche, **dadurch gekennzeichnet, dass** die Impedanzanpassungsschaltung (10) eine Übertragungsfunktion H(p) aufweist, die drei Pole ($\omega_{1-3}$) und eine Nullstelle ($\omega_z$) umfasst.

7. Sonde (1) nach dem vorhergehenden Anspruch, **dadurch gekennzeichnet, dass** die Eingangsschaltung (14) eine Eingangsimpedanz von mehr als 50 Gigaohm (G$\Omega$) aufweist.

8. Sonde (1) nach einem der vorhergehenden Ansprüche, **dadurch gekennzeichnet, dass** die Eingangsschaltung (14) eine Teilerbrücke (R1 und R2) umfasst.

9. Sonde (1) nach einem der vorhergehenden Ansprüche, **dadurch gekennzeichnet, dass** die Eingangsschaltung (14) mindestens einen Widerstand (R1) umfasst, der mindestens einen Schutzring (100) umfasst, der am Körper des Widerstands (R1) befestigt ist.

10. Sonde (1) nach dem vorhergehenden Anspruch, **dadurch gekennzeichnet, dass** der Schutzring (100) des mindestens einen Widerstands (R1) einen auf der Mitte des Widerstandskörpers (R1) befestigten Ring (102) aus Edelstahl und ein Metallgeflecht (104) umfasst, das den Ring (102) mit einer Masse (G) verbindet.

**Claims**

1. An active probe (1) for measuring a voltage across a high impedance load of at least 10 gigaohms (G$\Omega$), said probe (1) comprising:

   - an impedance matching circuit (10) configured, on the one hand, to have an input impedance at least 100 times greater than the impedance to be measured and, on the other hand, to output a low-impedance signal;
   - a tip (6) configured for measurement and connected to said impedance matching circuit (10);
   - a ground reference (G) connected to said impedance matching circuit (10);

     said impedance matching circuit (10) comprising, in cascade, at least one input circuit (14) and a non-inverting amplifier assembly (16) suitable for high impedance values,
     **characterised in that** the non-inverting amplifier assembly (16) comprises an operational amplifier (AO1), as well as a resistor (R5) disposed at the inverting input of said operational amplifier (AO1),
     and **in that** the amplifier assembly (16) comprises a guard ring (20) surrounding the inverting and non-inverting inputs of the operational amplifier (A01) and at least partially the fifth resistor (R5).

2. The probe (1) according to the preceding claim, **characterised in that** the low impedance output of said impedance matching circuit (10) has an impedance of 50 ohms or less.

3. The probe (1) according to any one of the preceding claims, **characterised in that** the impedance matching circuit (10) comprises at least one component (C2, C3, R4) and/or a filtering circuit (18).

4. The probe (1) according to any one of the preceding claims, **characterised in that** said probe (1) is configured to measure a direct-current voltage and/or having a frequency below 60 Hz.

5. The probe (1) according to any one of the preceding claims, **characterised in that** it is configured to measure an impedance greater than 10 Gigaohms (G$\Omega$), preferably between 10 and 50 Gigaohms (G$\Omega$).

6. The probe (1) according to any one of the preceding claims, **characterised in that** the impedance matching circuit (10) has a transfer function H(p) including three poles ($\omega_{1-3}$) and one zero ($\omega_z$).

7. The probe (1) according to the preceding claim, **characterised in that** the input circuit (14) has an input impedance greater than 50 Gigaohms (G$\Omega$).

8. The probe (1) according to any one of the preceding claims, **characterised in that** the input circuit (14) comprises a divider bridge (R1 and R2).

9. The probe (1) according to any one of the preceding claims, **characterised in that** said input circuit (14) comprises at least one resistor (R1) including at least one guard ring (100) attached to the body of said resistor (R1).

10. The probe (1) according to the preceding claim, **characterised in that** the guard ring (100) of said at least one resistor (R1) comprises a stainless steel ring (102) attached to the middle of the body of the resistor (R1) and a metal braid (104) connecting said ring (102) to a ground (G).

[Fig. 1]

[Fig. 2]

[Fig. 3]

EP 4 409 301 B1

[Fig. 4]

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5952820 A